# FASCICULE DE BREVET EUROPEEN

(11) **EP 0 527 085 B1**
(45) Date de publication et mention de la délivrance du brevet: **19.06.1996**
(21) Numéro de dépôt: 92402226.2
(22) Date de dépôt: 04.08.1992
(51) Int. Cl.: H01L 31/0203, H01L 31/0216, H01L 27/148, G02B 1/10, G02B 13/16

(54) **Détecteur photoélectrique à transfert de charges à qualité d'image améliorée**
Ladungstransfer-Photodetektor mit verbesserter Bildqualität
Charge transfer photodetector with improved image quality

(30) Priorité: 06.08.1991 FR 9110010
(43) Date de publication de la demande: 10.02.1993
(73) Titulaire: SFIM INDUSTRIES, F-91300 Massy (FR)
(72) Inventeur: Boureau, Philippe, F-78117 Chateaufort (FR); Patry, Philippe, F-92260 Fontenay-Aux-Roses (FR)
(74) Mandataire: Schrimpf, Robert

(56) Documents cités:
- EP-A- 0 307 233
- US-A- 2 220 861
- FUNKSCHAU, vol. 62, no. 8, 6 Avril 1990, München, DE, pp. 56-59, A. NOLTE: 'CCDs-Augen für die Videokamera'
- PATENT ABSTRACTS OF JAPAN vol. 11, no. 61 (E-483)(2508) 25 Février 1987 & JP-A-61 220 460
- NAUMANN et al.: 'Bauelement der Optik', 1987, CARL HANSER VERLAG, München, p. 74

## Description

La présente invention concerne un détecteur photoélectrique comprenant une matrice d'éléments à transfert de charges, qui est divisée en une zone-image et une zone-mémoire, ce détecteur étant muni d'une vitre de fermeture présentant une face interne, tournée vers ladite matrice, et une face externe, opposée à la face interne.

L'invention trouve une application particulièrement avantageuse dans l'utilisation des détecteurs photoélectriques matriciels à transfert de charges, en particulier les détecteurs connus sous le nom de CCD (de l'anglo-saxon "Charge Coupled Device").

Actuellement, la plupart des détecteurs photoélectriques conformes au préambule, destinés à fournir des images vidéo, sont enfermés dans un boîtier en céramique permettant la fixation et les connexions, sur lequel est montée hermétiquement la vitre de fermeture de la matrice, généralement constituée d'une simple lame de verre.

Lorsqu'on utilise ces détecteurs CCD pour la détection de phénomènes optiques ayant une intensité lumineuse normale ou faible, en présence de sources naturelles, telles que le soleil, ou artificielles ayant des intensités lumineuses intenses, et donc gênantes, dirigées approximativement suivant l'axe optique de ces dispositifs, la protection traditionnelle de la zone-mémoire, consistant à recouvrir directement cette zone par application d'une couche métallique d'aluminium, s'avère insuffisante. Cette solution classique est décrite, par exemple, dans l'article de A. VOLTE "CCDs - Augen für die Videokamera" paru dans la revue FUNKSCHAU, vol, 62, N° 8, 6 Avril 1990, pages 56 à 59.

En outre, les dioptres constituées par les faces interne et externe de la vitre sont à l'origine de réflexions multiples qui créent des anneaux parasites, qui affectent la résolution de l'image formée.

On connaît déjà par le document EP-A-0 307 233 un détecteur photoélectrique dont la face exposée présente un masque de protection qui comporte une ouverture en regard de la zone-image du détecteur, la face interne de la vitre de fermeture étant recouverte d'une couche absorbante comportant également une ouverture en regard de ladite zone image.

Un tel dispositif ne permet cependant pas de résoudre le problème des réflexions multiples.

L'emploi de couches antireflet sur une vitre est également déjà connu en soi. Il a notamment été décrit dans US-A-2 220 861.

Selon l'invention, le problème des réflexions multiples est résolu en ce que le système de couches antireflet s'étend également sur la zone de la face interne de la vitre de fermeture correspondant à ladite ouverture du masque de protection et en ce qu'un système de couches antireflet est également appliqué sur la face externe de la vitre de fermeture.

Avantageusement, le masque de protection conforme à l'invention est constitué d'une couche métallique, réalisée de préférence en chrome, notamment par dépôt sous vide.

La description qui va suivre en regard des dessins annexés, donnés à titre d'exemples non limitatifs, fera bien comprendre en quoi consiste l'invention et comment elle peut être réalisée.

La figure 1 est une vue partielle en coupe d'une vitre de fermeture d'un détecteur photoélectrique selon l'invention.

La figure 2 est une vue de dessus de la face interne de la vitre de fermeture de la figure 1.

La figure 3 est une vue de dessus de la face externe de la vitre de fermeture de la figure 1.

La figure 4 est une vue en coupe d'un photodétecteur selon l'invention.

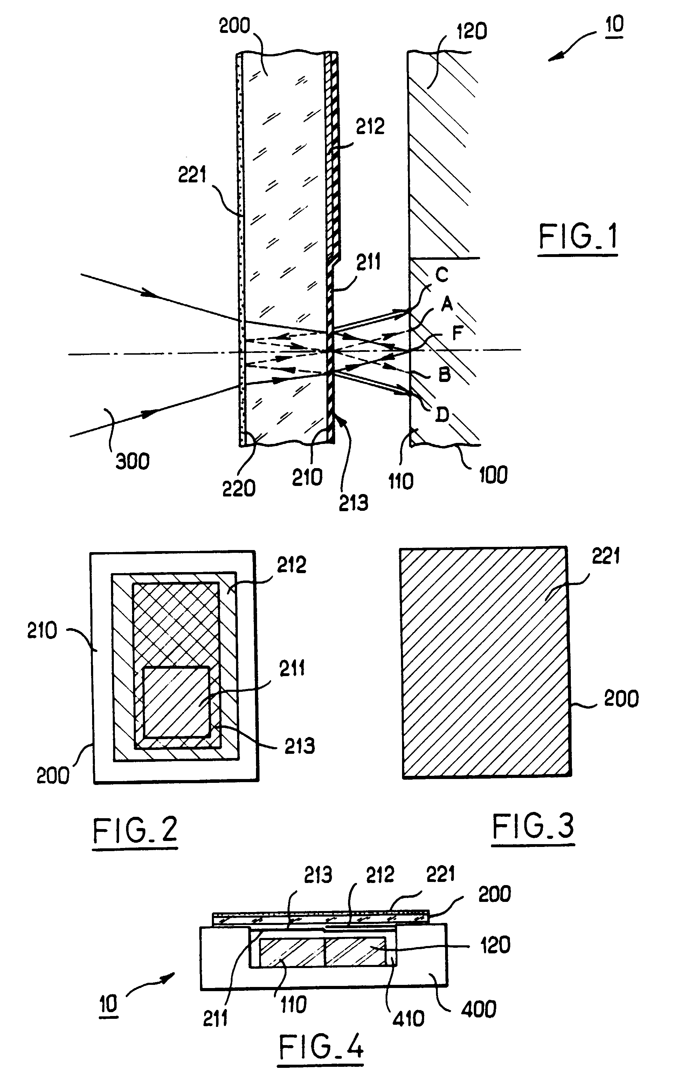

La figure 1 montre en coupe une vue partielle d'un détecteur photoélectrique 10 comprenant une matrice 100 d'éléments à transfert de charges, par exemple une matrice du type connu sous le sigle de CCD. D'une manière générale, la face avant de la matrice comportant les éléments à transfert de charges est placée au plan focal d'un instrument optique, non représenté, de façon à y former l'image d'une scène à observer. La figure 1 montre un faisceau lumineux 300, fourni par ledit instrument d'optique, qui converge au point F à la surface de la matrice 10 après traversée d'une vitre 200 de fermeture dont est munie la matrice 100. Cette vitre de fermeture est destinée à protéger de façon classique mécaniquement la surface sensible de la matrice.

Or, la vitre de fermeture classique présente des caractéristiques incompatibles avec la transcription photoélectrique de scènes fortement contrastées. En effet, pour des rayons lumineux inclinés, ce qui est le cas dans l'espace situé entre une optique de focalisation et le plan focal de cette optique où se trouve la matrice à transfert de charges, il se produit des images secondaire, tertiaire, etc... d'intensité décroissante, dues aux réflexions multiples sur les faces interne et externe de la vitre de fermeture. Si l'on désigne par T et R les facteurs de transmission et de réflexion du dioptre formé par une des faces de la vitre et l'air, le rayon utile possède une intensité T², l'image secondaire une intensité T²R², et l'image d'ordre n une intensité T²R⁽²ⁿ²⁾. A titre d'exemple, pour un verre de fermeture d'indice 1,5, on obtient les intensités relatives suivantes :
- 1er rayon:: 0,92
- 2ème rayon:: 0,0014
- 3ème rayon:: 2,3 x 10⁻⁶
- 4ème rayon:: 4 x 10⁻⁹

La décroissance est donc assez rapide, mais on voit nettement que le rayon d'ordre 2 peut créer un halo centré autour du vrai foyer représentant un flux de l'ordre de 1,5 % du flux utile, ce qui, compte tenu de la dynamique des détecteurs qui est de 4000 environ, peut effectivement donner lieu à un phénomène visible, principalement lorsque l'intensité de l'image sur le détecteur dépasse la dynamique de celui-ci. Le rendu des scènes à fort contraste en est donc affecté.

Un autre phénomène, lié également à la vitre de fermeture classique, est susceptible de provoquer un inconvénient encore plus néfaste provenant du fait que la surface sensible de la matrice à éléments à transfert de charges est généralement constituée par un matériau relativement réfléchissant tel que le silicium. Si on suppose que le flux réfléchi est de 30 % par rapport au flux incident et pour les mêmes paramètres de vitre de fermeture que précédemment, le faisceau incident crée un faisceau parasite formant un halo dont le flux est de 1,2 % du flux utile.

Comme on peut le voir sur la figure 1, la vitre 200 de fermeture présente deux faces, une face interne 210, tournée vers la matrice 100 et une face externe 220 opposée à la face interne, chacune de ces faces comportant un système de couches anti-reflet, respectivement 211 et 221, couvrant au moins la surface de la matrice 100 d'éléments à transfert de charges.

Les couches anti-reflet 211 et 221 sont réalisées de façon classique par dépôt sous vide de couches diélectriques ou métalliques minces dont le nombre, l'épaisseur et la composition dépendent des facteurs de réflexion et de transmission désirés ainsi que de la bande spectrale considérée.

L'effet des couches anti-reflet 211 et 221 est, d'une part, d'augmenter la transmission optique globale de la vitre 200 de fermeture en limitant les réflexions sur les dioptres constitués par les faces interne 210 et externe 220 de la vitre, et, d'autre part, de réduire sensiblement les halos parasites provenant de ces réflexions.

Un premier type de halo parasite est représenté par le segment AB de la coupe de la figure 1. Ce halo provient des rayons lumineux, montrés en traits pointillés sur la figure 1, résultant de la double réflexion sur les faces interne 210 et externe 220 de la vitre 200 de fermeture des rayons périphériques du faisceau lumineux 300. Le halo AB, centré autour du foyer F, affecte la résolution de l'image formée sur la matrice 100 d'éléments à transfert de charges. Ce halo AB ne constitue d'ailleurs que la première d'une série d'images parasites d'intensité décroissante et de dimension croissante provenant des réflexions multiples à l'intérieur de la vitre 200 de fermeture.

Un deuxième type de halo parasite encore plus gênant car plus lumineux et plus large que le halo AB, est le halo noté CD sur la figure 1. Ce deuxième halo parasite est dû à la double réflexion du faisceau lumineux incident sur la surface réfléchissante de la matrice 100, puis sur la face 210 de la vitre 200 de fermeture. Les rayons extrêmes formant le halo CD sont représentés par un double trait sur la figure 1.

Comme cela a été discuté plus haut, ces halos parasites, qui peuvent être très néfastes pour la qualité de l'image formée dans le cas de fort contraste, sont considérablement atténués du fait de la présence des couches anti-reflet 211 et 221.

Selon la largeur spectrale utilisée, le traitement anti-reflet de la vitre de fermeture peut naturellement être d'une efficacité plus ou moins grande. Cependant, même dans le cas d'une utilisation de tout le spectre du détecteur, le gain est considérable. En effet, la réflexion de 4 % pour un dioptre air-verre, tel qu'envisagé précédemment, s'établit à 1 % maximum pour un système de couches anti-reflet large bande et à 0,2 % pour une largeur spectrale de 100 nm environ. Elle peut même tomber à quelques ppm pour une lumière monochromatique. Les valeurs d'intensités relatives deviennent alors les suivantes :

| | traitement anti-reflet large bande | traitement anti-reflet bande étroite |
|---|---|---|
| 1er rayon : | 0,98 | 0,996 |
| 2ème rayon : | 10⁻⁴ | 4x10⁻⁶ |
| 3ème rayon : | 10⁻⁸ | 1,6x10⁻¹¹ |
| 4ème rayon : | 10⁻¹² | 6x10⁻¹⁷ |

A titre d'exemple, pour le deuxième rayon donnant lieu à une image dite secondaire, le passage d'une vitre de fermeture simple à une vitre comportant des couches anti-reflet bande étroite fait diminuer dans un rapport 35 l'intensité de cette image secondaire.

Quant aux valeurs de l'intensité du halo résultant de la réflexion sur la surface de la matrice elle-même, on obtient :

| sans traitement | avec traitement anti-reflet large bande | avec traitement anti-reflet bande étroite |
|---|---|---|
| 1,2 % | 0,3 % | 0,06 % |

Le gain est ici de 20 fois.

Un autre avantage du détecteur photoélectrique de l'invention concerne la transmission optique qui passe de 0,92 à 0,99 en moyenne, soit une augmentation sensible de 7 % de la sensibilité utile de celui-ci.

La figure 1 montre, par ailleurs, une matrice 100 à éléments à transfert de charges divisée en une zone-image 110 proprement dite et une zone-mémoire 120 qui ne doit pas recevoir de flux lumineux. Comme il apparaît sur la figure 1, ladite face interne 210 comporte également, entre la vitre 200 de fermeture et ledit système de couches anti-reflet 211, une couche métallique 212, obtenue par exemple par dépôt sous vide de chrome, couvrant au moins ladite zone-mémoire 120 et présentant une ouverture 213 en regard de ladite zone-image 110.

Cette technique de masquage des zones du détecteur qui ne sont pas utiles à l'image présente plusieurs avantages. Elle permet notamment d'éviter que la zone-mémoire puisse être altérée par la lumière incidente. Cette zone-mémoire, connexe à la zone sensible, est également en silicium et, bien qu'elle soit protégée de la lumière directe par un dépôt métallique prévu par le constructeur, cette protection s'avère en général insuffisante dans le cas d'éclairements importants, dus à des sources naturelles, telles que le soleil, ou à des sources artificielles.

D'autre part, le fait de délimiter par masquage la zone sensible permet de diminuer les effets de bord généralement créés par de la lumière incidente réfléchie, soit par des zones de connexion, soit par des fils de connexion, et qui peut être renvoyée sur la zone-image.

En outre, l'association d'une couche métallique appliquée directement sur le verre de la vitre de fermeture qui est ensuite complétée par une couche anti-reflet possède des caractéristiques absorbantes qui réalisent un piège à lumière, -c'est-à-dire une absorption au moins dans la région spectrale utile du phénomène détecté-, dont l'intérêt est de diminuer les flux lumineux parasites dus à des rayons situés hors du champ utile et qui pourraient revenir sur les lentilles de focalisation et être alors renvoyés dans le champ utile et donc vers la zone-image du détecteur.

La figure 2 montre en vue de dessus un mode de réalisation de la face interne 210 de la vitre 200 d'ouverture de la figure 1. On peut voir la couche métallique 212 et l'ouverture 213 permettant au flux lumineux incident de traverser ladite vitre et d'atteindre la zone-image. La figure 2 montre également la couche anti-reflet 211 couvrant l'ouverture 213 et partiellement la couche métallique 212.

La figure 3 représente la face externe 220 de la vitre 200 de fermeture comportant une couche anti-reflet 221 sur toute sa surface.

La figure 4 montre un détecteur photoélectrique 10 complet dont la vitre 200 de fermeture est conforme à celle représentée par l'ensemble des figures 2 et 3. On notera que les bords de la face interne 210 ne portant aucune couche sont directement collés sur le boîtier 400 du détecteur photoélectrique 10. D'autre part, le fait que, à l'exception de l'ouverture 213, la couche métallique occupe une surface équivalente à celle du logement 410 dans lequel est placée la matrice 100 permet non seulement d'éviter d'éclairer la zone-mémoire 120 mais également de réaliser en dehors de l'ouverture 213 en regard de la zone-image 110, une couche absorbante résultant de la combinaison de la couche métallique 212 et de la couche anti-reflet 211.

## Revendications

1. Détecteur photoélectrique comprenant une matrice (100) d'éléments à transfert de charges, qui est divisée en une zone-image (110) et une zone-mémoire (120), ce détecteur étant muni d'une vitre de fermeture (200) présentant une face interne (210), tournée vers la matrice, et une face externe (220),opposée à la face interne, la face interne (210) présentant un masque de protection d'au moins ladite zone-mémoire (120) contre des éclairements intenses, ce masque (212) présentant une ouverture (213) en regard de ladite zone-image (110), la face interne (210) de la vitre (200) de fermeture présentant un système de couches antireflet (211) couvrant le masque de protection (212), caractérisé en ce que le système de couches antireflet (211) s'étend également sur la zone de la face interne de la vitre de fermeture correspondant à ladite ouverture (213) du masque de protection (212) et en ce qu'un système de couches antireflet (221) est également appliqué sur la face externe (220) de la vitre de fermeture (200).

2. Détecteur photoélectrique selon la revendication 1, caractérisé en ce que ledit masque de protection est constitué d'une couche métallique (212).

3. Détecteur photoélectrique selon la revendication 2, caractérisé en ce que ladite couche métallique est réalisée en chrome.

4. Détecteur photoélectrique selon la revendication 3, caractérisé en ce que ladite couche métallique est en chrome déposé sous vide.

5. Détecteur photoélectrique selon l'une quelconque des revendications 1 à 4, caractérisé en ce que la matrice (100) à éléments à transfert de charges étant placée à l'intérieur d'un logement (410) d'un boîtier (400), ledit masque de protection (212) occupe une surface équivalente à celle dudit logement (410).

## Patentansprüche

1. Photodetektor mit einer Matrix (100) von Ladungsverschiebeelementen, die in eine Bildzone (110) und eine Speicherzone (120) geteilt ist, wobei dieser Detektor mit einer Abschlußscheibe (200) versehen ist, die eine der Matrix zugekehrte Innenfläche (210) und eine der Innenfläche gegenüberliegende Außenfläche (220) bietet, wobei die Innenfläche (210) eine Schutzmaske mindestens der besagten Speicherzone (120) gegen starke Bestrahlungen bietet, wobei diese Maske (212) eine Öffnung (213) zur besagten Bildzone (110) bietet, wobei die Innenfläche (210) der Abschlußscheibe (200) ein die Schutzmaske (212) bedeckendes System von Antireflexschichten (211) bietet, dadurch gekennzeichnet, daß das System von Antireflexschichten (211) sich auch auf die Zone der Innenfläche der Abschlußscheibe entsprechend der besagten Öffnung (213) der Schutzmaske (212) erstreckt und daß ein System von Antireflexschichten (221) ebenfalls auf der Außenfläche (220) der Abschlußscheibe (200) angebracht ist.

2. Photodetektor nach Anspruch 1, dadurch gekennzeichnet, daß die besagte Schutzmaske aus einer Metallschicht (212) besteht.

3. Photodetektor nach Anspruch 2, dadurch gekennzeichnet, daß die besagte Schutzschicht aus Chrom besteht.

4. Photodetektor nach Anspruch 3, dadurch gekennzeichnet, daß die besagte Metallschicht vakuumaufgedampftes Chrom ist.

5. Photodetektor nach einem der Ansprüche 1 bis 4, dadurch gekennzeichnet, daß die Matrix (100) von Ladungsverschiebeelementen in einer Kammer (410) eines Kastens (400) angeordnet ist, wobei die besagte Schutzmaske (212) eine der der besagten Kammer (410) gleiche Oberfläche einnimmt.

## Claims

1. A photoelectric detector comprising a matrix (100) of charge coupled elements, divided into an image zone (110) and a memory zone (120), the detector being provided with a closure glass (200) having an inside face (210) facing towards the matrix and an outside face (220) opposite to its inside face, the inside face (210) having a protective mask for protecting at least the memory zone (120) against intense illumination, the mask (212) having an opening (213) overlying said image zone (110), the inside face (210) of the closure glass (200) having a system of antireflection layers (211) covering the protection mask (212), the detector being characterized in that the system of antireflection layers (211) also extends over the zone of the inside face of the closure glass that corresponds to said opening (213) of the protective mask (212), and in that a system of antireflection layers (221) is also applied to the outside face (220) of the closure glass (200).

2. A photoelectric detector according to claim 1, characterized in that said protective mask is constituted by a metallic layer (212).

3. A photoelectric detector according to claim 2, characterized in that said metallic layer is made of chromium.

4. A photoelectric detector according to claim 3, characterized in that said metallic layer is made of vacuum-deposited chromium.

5. A photoelectric detector according to any one of claims 1 to 4, characterized in that the matrix (100) of charge coupled elements is placed inside a housing (410) of a package (400), and said protective mask (212) occupied an area equivalent to that of said housing (410).
